# DEMANDE DE BREVET EUROPEEN

(11) **EP 1 178 522 A1**
(43) Date de publication de la demande: **06.02.2002**
(21) Numéro de dépôt: 01410097.8
(22) Date de dépôt: 03.08.2001
(51) Int. Cl.: H01L 21/20, H01L 33/00

(54) **Formation de boîtes quantiques**

(30) Priorité: 04.08.2000 FR 0010346
(71) Demandeur: STMicroelectronics S.A., 92120 Montrouge (FR)
(72) Inventeur: Bensahel, Daniel, 38100 Grenoble (FR); Kermarrec, Olivier, 38400 Saint Martin d'Heres (FR); Campidelli, Yves, 38000 Grenoble (FR)
(74) Mandataire: de Beaumont, Michel

(57) **Abrégé**

L'invention concerne un procédé de formation, sur un substrat semiconducteur monocristallin (40) d'un premier matériau, de boîtes quantiques (41) en un second matériau, consistant à faire croître par épitaxie en phase gazeuse le second matériau sur le premier matériau dans des conditions optimales propres à assurer une croissance à une vitesse contrôlable maximum. Dans une étape initiale, on envoie sur le substrat une bouffée d'un gaz comprenant le second matériau, dans des conditions correspondant à une vitesse de dépôt nettement plus rapide que ladite vitesse contrôlable maximum.

## Description

La présente invention concerne la fabrication de "boîtes quantiques" d'un premier matériau dans un second matériau semiconducteur. Plus particulièrement, la présente invention concerne la réalisation de boîtes quantiques dans un substrat de silicium.

De telles boîtes quantiques sont, par exemple, décrites dans le document "Ge/Si self-assembled quantum dots grown on Si (100) in an industrial high-pressure chemical vapor deposition reactor" de C. Hernandez, Y. Campidelli, D. Simon, D. Bensahel, I. Sagnes, G. Patriarche, P. Boucaus et S. Sauvage, paru dans J. Appl. Phys., 86/2, 1999, 1145-1148. Elles sont utilisées dans de très nombreux domaines d'application. On considère ci-après à titre d'exemple non-limitatif le domaine des télécommunications.

Dans le domaine des télécommunications, on utilise de façon croissante des systèmes à base de fibres optiques. Pour ce faire, on recourt à des émetteurs propres à convertir une différence de potentiel en un signal lumineux et à des récepteurs propres à convertir un signal lumineux transmis par une fibre optique en un signal électrique. Le signal lumineux émis et/ou reçu est généralement situé dans une plage de longueurs d'onde comprise entre 1,4 et 1,5 µm.

Jusqu'à une période récente, on a utilisé, pour réaliser de tels récepteurs et/ou émetteurs, des combinaisons de matériaux des colonnes III et V de la classification périodique des éléments. Par exemple, l'arséniure de gallium (AsGa) ou l'indiure de phosphore (InP).

On préférerait toutefois utiliser pour les émetteurs et récepteurs optiques des matériaux à base de silicium, mais le recours au silicium pose différents problèmes. Tout d'abord l'intervalle de bande d'énergie du silicium entre ses bandes de valence et de conduction est relativement faible et les transitions sont de type "indirect". Par "indirect", on entend que le passage d'un électron de la bande de valence à la bande de conduction se fait en plusieurs sauts et non en un seul saut comme dans le cas des composés III-V. Le silicium est alors presque inutilisable comme émetteur, c'est-à-dire convertisseur d'énergie électrique en énergie lumineuse. En effet, du fait du caractère indirect des transitions électroniques, celles-ci sont fortement dissipatrices et très faiblement émettrices. En outre, l'intervalle de bande d'énergie relativement faible, de l'ordre de 1,1 eV, correspond à une émission de photons d'une longueur d'onde inférieure à 1 µm, peu utilisée dans le domaine des télécommunications.

On a donc proposé d'améliorer les propriétés optiques, c'est-à-dire d'émission et de réception, du silicium en formant dans celui-ci des boîtes quantiques.

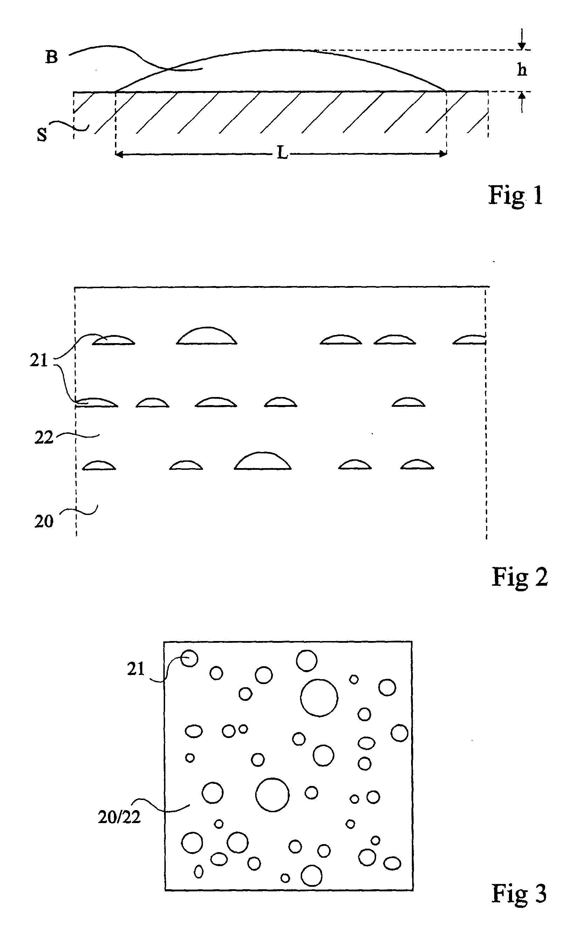

La figure 1 illustre, en vue en coupe partielle et schématique, une boîte quantique telle que décrite, par exemple, dans l'article susmentionné du Journal of Applied Physics. Cette boîte B est constituée d'un îlot de germanium formé sur un substrat S de silicium monocristallin. Bien que théoriquement on souhaite former un cube parfait d'une arête inférieure à 50 nm, on réalise en pratique une nanostructure en forme de dôme ou goutte B, présentant une base L et une hauteur h. En pratique, on parvient à réaliser de telles boîtes de base L comprise entre 20 et 50 nm, et de hauteur comprise entre 6 et 30 nm. La boîte B est encapsulée dans une couche de silicium monocristallin.

Dans de nombreuses applications, pour obtenir des performances acceptables, par exemple un émetteur/récepteur d'une émissivité/réceptivité convenable, il est souhaitable de pouvoir réaliser plusieurs plans superposés contenant chacun plusieurs boîtes similaires à celles de la figure 1.

Comme l'expose l'article cité précédemment, la formation de dômes ou gouttes résulte d'un mécanisme de contrainte entre des mailles cristallographiques de dimensions différentes, mais relativement voisines, de deux semiconducteurs. On a montré que ce procédé de croissance, dit de Stranski-Krastanow, provoque, par exemple, la formation de gouttes de germanium sur du silicium à partir de divers procédés de dépôt comprenant des épitaxies moléculaires, des dépôts chimiques en phase vapeur sous faible pression, ou des dépôts chimiques en phase vapeur sous vide important.

Plus particulièrement, pour former des boîtes quantiques de germanium dans du silicium on effectue, par exemple, une épitaxie par injection continue de germane (GeH₄), sur un substrat de silicium monocristallin. Alors, les quelques premières épaisseurs atomiques déposées forment une couche dont la surface est régulière mais non plane. En raison des contraintes liées aux différences des réseaux cristallins, la surface présente une allure "ondulatoire" de type sinusoïdal. En d'autres termes, la surface supérieure d'une couche de germanium de quelques épaisseurs atomiques, formée sur du silicium, présente des creux et des bosses répartis de façon régulière. L'injection de germane se poursuivant, les contraintes cristallographiques - déformations du réseau naturel du germanium - provoquent la croissance de gouttes ou boîtes similaires à celles de la figure 1. Cette injection doit être interrompue quand les gouttes ou boîtes ont atteint une dimension souhaitée, avant que ne se produise une coalescence des gouttes, puis la formation d'une couche continue contenant des dislocations.

On procède ensuite à une croissance épitaxiale d'une couche de silicium qui encapsule les boîtes de germanium.

La figure 2 illustre, en vue en coupe partielle et schématique, le résultat de la mise en oeuvre répétée d'un tel procédé. Par exemple, on a formé, sur un substrat de silicium 20, trois plans sensiblement horizontaux de gouttes de germanium (boîtes quantiques) 21 encapsulées dans du silicium 22.

La figure 3 illustre, en vue de dessus partielle et schématique, l'un quelconque des plans de gouttes 21.

On cherche à obtenir des densités de boîtes aussi élevées que possible (≥ 10¹⁰ cm⁻²) et une répartition de taille aussi fixe que possible. Toutefois, comme l'illustrent très schématiquement les figures 2 et 3, la mise en oeuvre courante du procédé de croissance contrainte de Stranski-Krastanow conduit à des structures de gouttes hétérogènes tant en ce qui concerne la répartition des gouttes que leur taille. Pour faire ressortir toutes les difficultés de mise en oeuvre de ce procédé, on va rappeler les principales étapes de réalisation de l'épitaxie en phase gazeuse de gouttes de germanium sur un substrat de silicium.

Tout d'abord, l'état de surface du substrat de silicium joue un rôle important. On pense actuellement qu'il faut trouver un compromis optimal entre une homogénéité parfaite et une certaine répartition de défauts.

On s'aperçoit aussi que le choix des conditions de l'épitaxie doit satisfaire à un compromis. En effet, ces conditions doivent être choisies pour que l'épitaxie ne soit pas trop lente car, dans ce cas, les risques liés à la présence d'inévitables impuretés (apportées par les précurseurs gazeux et/ou liées au taux de fuite du réacteur) augmentent. Par contre, si la vitesse de croissance des gouttes de germanium est trop importante le processus devient difficilement contrôlable. En effet, cette croissance doit être interrompue de façon précise comme on l'a indiqué précédemment.

Ainsi, on définit pour des conditions données de pression, de débit, et de dilution des gaz, dans un réacteur d'épitaxie de type donné, une température "optimale" qui correspond à une vitesse de croissance "contrôlable" maximum, c'est-à-dire une vitesse aussi rapide que possible pour éviter les défauts susmentionnés, et suffisamment lente pour permettre d'interrompre l'épitaxie de façon précise à un stade souhaité (par exemple quelques dizaines de couches monoatomiques).

A titre d'exemple, une séquence typique de mise en oeuvre d'un procédé de Stranski-Krastanow à une température de l'ordre de 650°C (630 à 670°C) et à une pression comprise entre 0,02 et 0,04.10⁵ Pa (20 à 30 torr) comprend, en partant d'un substrat de silicium monocristallin, les étapes suivantes :
- injecter du silane dilué à 10 % dans de l'hydrogène pendant sensiblement 5 s, d'où il résulte la croissance de sensiblement de deux à trois monocouches de silicium monocristallin (étape optionnelle) ;
- injecter du germane dilué à 10 % dans de l'hydrogène pendant sensiblement 30 s, d'où il résulte la croissance de "gouttes" de germanium d'une hauteur correspondant à un empilement d'une trentaine d'atomes ; et
- réinjecter du silane de façon à former une couche d'encapsulation.

Selon cette séquence classique, les injections de silane et de germane sont effectuées successivement à des débits voisins. L'hydrogène (gaz porteur) est injecté à un débit d'environ 10 l/mn. Le débit des gaz injectés est maintenu généralement entre 15 et 25 cm³/mn, typiquement de l'ordre de 20 cm³/mn. Ce débit est choisi comme on l'a expliqué précédemment pour obtenir une vitesse de dépôt contrôlable maximum.

La présente invention vise à proposer un procédé de croissance de boîtes quantiques propre à former des boîtes régulières, agencées de façon homogène sur un substrat.

La présente invention vise également à proposer un tel procédé qui soit reproductible.

Pour atteindre ces objets, la présente invention prévoit un procédé de formation, sur un substrat semiconducteur monocristallin d'un premier matériau, de boîtes quantiques en un second matériau, consistant à faire croître par épitaxie en phase gazeuse le second matériau sur le premier matériau dans des conditions optimales propres à assurer une croissance à une vitesse contrôlable maximum, et comportant une étape initiale consistant à envoyer sur le substrat une bouffée d'un gaz comprenant le second matériau, dans des conditions correspondant à une vitesse de dépôt nettement plus rapide que ladite vitesse contrôlable maximum.

Selon un mode de réalisation de la présente invention, le premier matériau constituant le substrat est du silicium et le second matériau constituant les boîtes est du germanium.

Selon un mode de réalisation de la présente invention, le procédé est mis en oeuvre dans un réacteur d'épitaxie à une température de 630 à 670°C à une pression de 0,02 à 0,04 10⁵ Pa, lesdites conditions optimales correspondant à un débit de l'ordre de 15 à 25 cm³/mn de germane dilué à 10 % dans de l'hydrogène, et l'étape initiale consistant à envoyer une bouffée de germane dilué à 10 % dans de l'hydrogène à un débit de l'ordre de 200 cm³/mn pendant une durée de 1 à 5 s.

Selon un mode de réalisation de la présente invention, l'étape initiale d'envoi d'une bouffée est suivie d'une injection de germane dans lesdites conditions optimales pendant 25 à 40 s.

Selon un mode de réalisation de la présente invention, le premier matériau constituant le substrat est du silicium ou du germanium et le second matériau constituant les boîtes est une terre rare.

Selon un mode de réalisation de la présente invention, le premier matériau constituant le substrat est de l'oxyde de silicium et le second matériau constituant les boîtes est du nitrure de silicium.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 illustre, en vue en coupe partielle et schématique, une boîte quantique ;
la figure 2 illustre, en vue en coupe schématique et partielle, le résultat d'un procédé classique de croissance de plusieurs plans de boîtes quantiques ;
la figure 3 illustre, en vue de dessus partielle et schématique, l'un des plans de la structure de la figure 2 ;

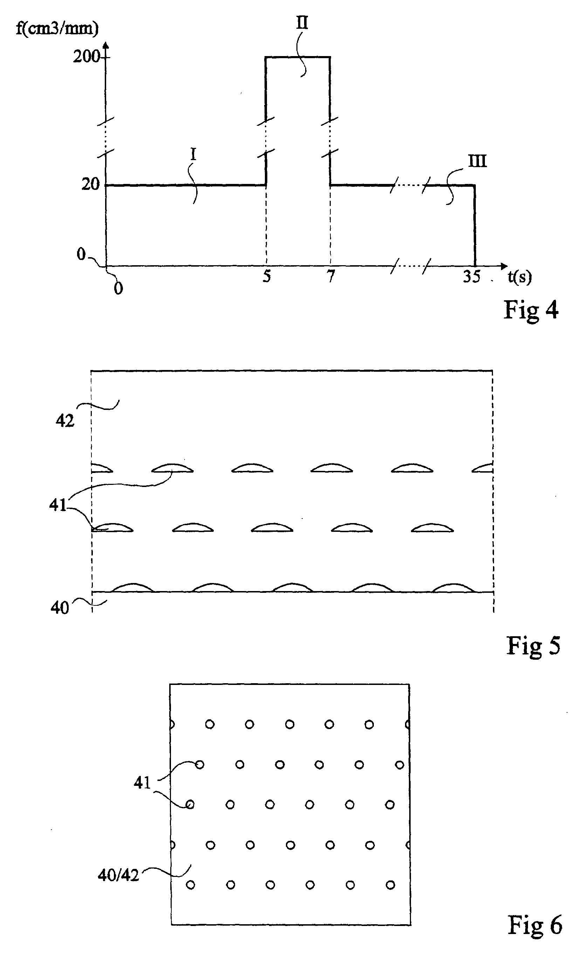

la figure 4 illustre des débits de gaz injectés selon un mode de réalisation de la présente invention ;
la figure 5 illustre, en vue en coupe schématique et partielle, le résultat d'un procédé de croissance de plusieurs plans de boîtes quantiques selon la présente invention ; et
la figure 6 illustre, en vue de dessus partielle et schématique, l'un des plans de la structure de la figure 5.

Par souci de clarté, les mêmes éléments ont été désignés par les mêmes références aux différentes figures et, de plus, comme cela est habituel dans la représentation des circuits intégrés, les diverses figures ne sont pas tracées à l'échelle.

Le procédé selon l'invention sera exposé ci-après en relation avec la figure 4 qui illustre l'évolution au cours du temps de débits de gaz injectés dans un réacteur d'épitaxie pendant la formation de boîtes quantiques. L'axe des abscisses du diagramme représente la durée d'injection t en secondes. L'axe des ordonnées représente le débit f en cm³/mn.

On considère à titre d'exemple non-limitatif que la température est maintenue à une valeur constante comprise entre 600 et 700°C, par exemple 635°C. De même on considère que la pression est maintenue à une valeur comprise entre 0,025 et 0,040.10⁵ Pa (20 à 30 torr).

Le procédé selon l'invention commence par des étapes initiales de nettoyage et de préparation de la surface de substrat monocristallin. Par exemple, on commence par faire croître quelques couches monoatomiques de silicium, par injection de silane. On injecte par exemple du silane dilué à 10 % dans de l'hydrogène pendant sensiblement 5 s à un débit compris entre 15 et 25 cm³/mn, par exemple 20 cm³/mn. Cette première étape est illustrée par la partie I, à gauche de la figure 4.

Ensuite, on effectue une injection d'un gaz contenant du germanium, par exemple du germane, pour former les boîtes quantiques. Toutefois, selon l'invention, cette injection commence par l'envoi d'une "bouffée" de germane. Par bouffée, on entend une injection d'une quantité élevée de germane pendant un temps bref. Par exemple, on injectera du germane dilué à 10 % dans de l'hydrogène à un débit moyen de 200 cm³/mn, pendant une durée de 2 s. Cette bouffée est illustrée par la partie centrale II de la figure 4, comprise entre les instants t = 5 et 7 s. Pendant cette bouffée, le débit moyen est nettement supérieur au débit optimal, permettant d'obtenir une vitesse de dépôt contrôlable maximum pour le réacteur considéré.

Ensuite, l'injection de germane se poursuit au débit optimal. Le flux est ramené à une valeur comprise entre 15 et 25 cm³/mn, par exemple de l'ordre de 20 cm³/mn, pendant une durée de 25 à 30 s, par exemple de 28 s. Le débit et la durée sont ajustés de façon à faire croître les quelques dizaines d'épaisseurs atomiques désirées des gouttes ou boîtes quantiques de germanium. Cette étape de croissance des gouttes est illustrée par la partie III à droite de la figure 4, comprise entre t = 7 s et t = 35 s.

Enfin, on provoque, toujours dans les mêmes conditions de pression, de débit et de température, la croissance d'une couche d'encapsulation de silicium. Par exemple, on injecte du silane dilué dans de l'hydrogène servant de gaz porteur à un débit de l'ordre de 20 cm³/mn. La durée de cette dernière étape est ajustée en fonction des conditions de pression, de débit et de température de façon à faire croître une couche d'encapsulation d'épaisseur voulue.

La séquence précédente d'étapes successives d'envoi d'une bouffée de germane, d'injection de germane à débit "optimal" et de croissance d'une couche d'encapsulation de silicium, peut ensuite être éventuellement répétée de façon à former autant de plans que nécessaire.

La figure 5 illustre, en vue en coupe partielle et schématique, la formation sur un substrat de silicium 40, de trois plans successifs de gouttes de germanium 41 encapsulées dans du silicium 42, par le procédé selon la présente invention.

La figure 6 illustre, en vue de dessus schématique et partielle, l'état d'un plan de gouttes 41 avant son encapsulation. Le plan considéré peut être le premier plan formé directement sur le substrat 40, ou un quelconque plan supérieur formé sur une couche d'encapsulation 42.

Comme l'illustrent les figures 5 et 6, les gouttes 41 formées par le procédé selon la présente invention présentent des dimensions homogènes et une répartition uniforme sur et dans le silicium 40-42. Cette répartition est uniforme tant en termes de régularité d'écart entre les gouttes 42 sur un plan donné qu'en termes d'identité de densité entre deux plans distincts.

Cette amélioration a été constatée expérimentalement, sans qu'elle soit expliquée de manière théorique. Sans que cela constitue une limitation de l'invention, on peut penser que les améliorations ainsi observées sont dues à la détente très rapide et importante de la bouffée initiale. En effet, en moins de cinq secondes, une forte quantité de gaz comprenant le germanium passe de la pression atmosphérique à la pression nettement inférieure de la chambre d'épitaxie. On peut supposer qu'une telle détente provoque un effet de pulvérisation ("spray") qui limite la diffusion du germanium à la surface du substrat. Cet effet de pulvérisation ne laisserait donc pas le temps aux atomes de germanium de diffuser et de s'organiser à la surface du substrat de façon à former une couche régulière. Par contre, il provoquerait une nucléation forcée par un "collage" homogène du germanium sur le substrat, les points de collage constituant autant de points de nucléation lors de la croissance régulière ultérieure. La reproductibilité de la structure dépend alors de la reproductibilité de la bouffée initiale.

La présente invention permet donc avantageusement d'obtenir, à partir d'un procédé simple à mettre en oeuvre, et à relativement basse température, des boîtes quantiques de germanium réparties de façon homogène régulière et reproductible sur au moins un plan dans du silicium.

Les avantages obtenus en termes d'applications sont multiples. Par exemple, dans le domaine des télécommunications, il est possible de former ainsi des dispositifs suffisamment sensibles et dans un domaine de longueurs d'ondes adéquat pour constituer des émetteurs. Les dispositifs obtenus à l'aide d'un procédé classique ne pouvaient par contre être utilisés que comme détecteurs. Par rapport à ces détecteurs classiques, ceux obtenus à l'aide du procédé selon la présente invention présentent une détectivité améliorée.

Bien entendu, la présente invention est susceptible de diverses variantes et modifications qui apparaîtront à l'homme de l'art. En particulier, les dimensions des boîtes quantiques, qui sont définies par les seules conditions d'injection et dont dépend la longueur d'onde de fonctionnement du dispositif global, peuvent être modifiées de toute façon appropriée.

Par ailleurs, on a considéré dans la présente description la formation de boîtes de germanium dans du silicium. Toutefois, la présente invention s'applique également à d'autres types de matériaux. On pourra par exemple procéder de la façon décrite pour former des centres de nucléation lors de la formation d'un tricouche de type oxyde de silicium - nitrure de silicium - oxyde de silicium. Plus précisément, le procédé de l'invention permettrait alors, après une formation classique d'une sous-couche d'oxyde de silicium, de provoquer la croissance de gouttes de nitrure de silicium encapsulées dans l'oxyde de silicium au lieu d'une couche intermédiaire continue. Ce type de structure serait utile dans des applications dans lesquelles on souhaite obtenir une variation de la constante diélectrique ou pour limiter la diffusion de dopants dans la structure lors de recuits ultérieurs et s'appliquerait en particulier à des mémoires à faible nombre d'électrons.

Le procédé de l'invention permet également d'introduire des boîtes quantiques de terres rares telles que l'erbium (Er), dans des substrats de silicium, de germanium et/ou d'alliages silicium-germanium contraints ou relaxés.

La présente invention s'applique également à la formation de nanostructures métalliques dans des matrices isolantes. Ceci permet de modifier la constante diélectrique de l'isolant.

De façon générale, la présente invention s'applique à la formation par dépôt chimique en phase vapeur de boîtes quantiques de tout matériau dans un quelconque substrat.

## Revendications

1. Procédé de formation, sur un substrat semiconducteur monocristallin (40) d'un premier matériau, de boîtes quantiques (41) en un second matériau, consistant à faire croître par épitaxie en phase gazeuse le second matériau sur le premier matériau dans des conditions optimales propres à assurer une croissance à une vitesse contrôlable maximum, **caractérisé en ce qu'**il comporte une étape initiale consistant à envoyer, sur le substrat, une bouffée d'un gaz comprenant le second matériau, dans des conditions correspondant à une vitesse de dépôt nettement plus rapide que ladite vitesse contrôlable maximum.

2. Procédé selon la revendication 1, **caractérisé en ce que** le premier matériau constituant le substrat est du silicium et le second matériau constituant les boîtes est du germanium.

3. Procédé selon la revendication 2, mis en oeuvre dans un réacteur d'épitaxie à une température de 630 à 670°C à une pression de 0,02 à 0,04 10⁵ Pa dans lequel lesdites conditions optimales correspondent à un débit de l'ordre de 15 à 25 cm³/mn de germane dilué à 10 % dans de l'hydrogène, **caractérisé en ce que** l'étape initiale consiste à envoyer une bouffée de germane dilué à 10 % dans de l'hydrogène à un débit de l'ordre de 200 cm³/mn pendant une durée de 1 à 5 s.

4. Procédé selon la revendication 3, **caractérisé en ce que** l'étape initiale d'envoi d'une bouffée est suivie d'une injection de germane dans lesdites conditions optimales pendant 25 à 40 s.

5. Procédé selon la revendication 1, **caractérisé en ce que** le premier matériau constituant le substrat est du silicium ou du germanium et le second matériau constituant les boîtes est une terre rare.

6. Procédé selon la revendication 1, **caractérisé en ce que** le premier matériau constituant le substrat est de l'oxyde de silicium et le second matériau constituant les boîtes est du nitrure de silicium.
